# EUROPEAN PATENT APPLICATION

(11) **EP 1 930 649 A1**
(43) Date of publication of application: **11.06.2008**
(21) Application number: 07020907.7
(22) Date of filing: 25.10.2007
(51) Int. Cl.: F21L 4/00, G01R 31/36

(54) **Flashlight with LCD display**

(30) Priority: 05.12.2006 CN 200620154362 U
(71) Applicant: Liu, Yunzhao, Nantou Zhongshan Guangdong 528427 (CN)
(72) Inventor: Liu, Yunzhao, Nantou Zhongshan Guangdong 528427 (CN)
(74) Representative: Thurgood, Alexander John

(57) **Abstract**

A flashlight includes a main part (1), a light source (12), a switch (11), an LCD display (2), and a control device (3); the control device (3) will measure the electricity content of the batteries (13) with a result of the measurement being shown on the LCD display (2); the length of time the batteries (13) will last is also shown on the LCD display (2); the switch (11) can be displaced to either one of several different positions, and the control device (3) will make the light source (12) produce light in a manner according to the position of the switch (11), e.g. flashing on and off repeatedly, and keeping on shining; in other words, the flashing frequency and brightness of the light source can be changed with the help of the switch (11) and the control device (3); the LCD display (2) will show information about the way the light source (12) is producing light at the same time.

## Description

### BACKGROUND OF THE INVENTION

### 1. Field of the invention

The present invention relates to a flashlight, more particularly one, which can be changed in its brightness, and can be switched so as either to keep on shining or to flash on and off repeatedly, and which has an LCD display capable of showing the electricity content of the batteries and the length of time the batteries will last.

### 2. Brief Description of the Prior Art

Flashlights are usually used to provide illumination in the dark, thus allowing people to see more clearly in searching, repairing, acting or walking. Therefore, flashlights are indispensable.

A conventional flashlight structure includes a hollow main part, a lamp shade member, a light source fitted to a front end of the hollow main part, a switch fitted on the hollow main part, and a rear cover fitted over a rear end of the hollow main part. The lamp shade member is joined to the front end of the hollow main part so as to be around the light source.

Light will be emitted from the front end of the flashlight to provide illumination when the flashlight is turned on by means of the switch. However, such flashlights can only produce light for illumination, and don't have other functions therefore they can't attract or satisfy those people who like to buy and use multifunction products.

### SUMMARY OF THE INVENTION

It is a main object of the invention to provide an improvement on flashlight to provide people with more convenience. The flashlight of the present invention includes a main part, a light source, a switch, an LCD display, and a control device. The control device will measure the electricity content of the batteries with a result of the measurement being shown on the LCD display, and the length of time the batteries will last is also shown on the LCD display. The switch can be displaced to either one of several different positions, and the control device will make the light source produce light in a way according to the position of the switch, e.g. flashing on and off repeatedly, and keeping on shining; in other words, the flashing frequency and brightness of the light source can be changed with the help of the switch and the control device. And, the LCD display will show information about the way the light source is producing light at the same time.

### BRIEF DESCRIPTION OF THE DRAWINGS

The present invention will be better understood by referring to the accompanying drawings, wherein:
Fig. 1 is a perspective view of the present invention,
Fig. 2 is a structural block diagram of the present invention,
Fig. 3 is a circuit diagram of the present invention (1), and
Fig. 4 is a circuit diagram of the present invention (2).

### DETAILED DESCRIPTION OF THE PREFERRED EMBODIMENTS

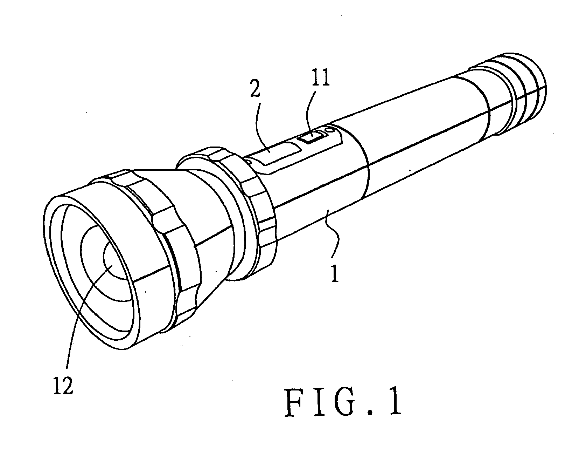

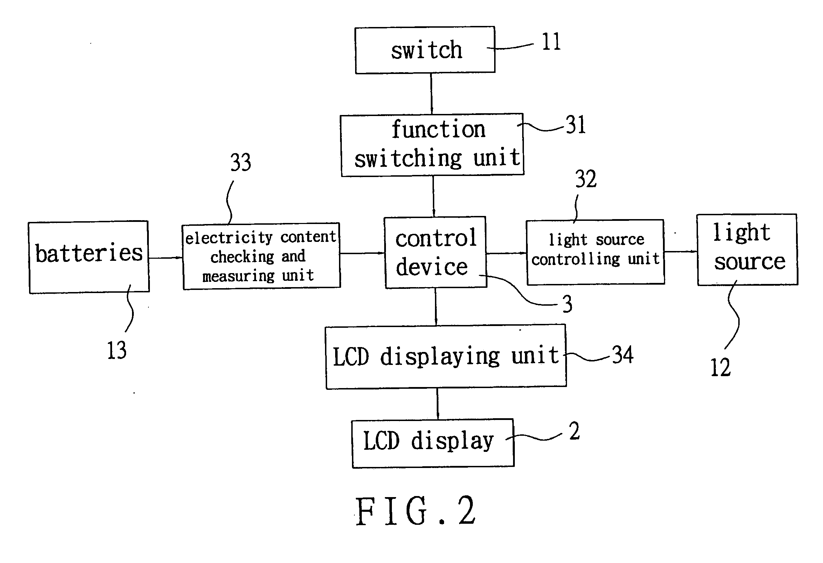

Referring to Figs. 1 and 2, a preferred embodiment of a flashlight of the present invention includes a main part 1, a switch 11, a light source 12, an LCD display 2, and a control device 3.

The switch 11 is fitted on the main part 1. The light source 12 is fitted to a front end of the main part 1, and batteries 13 are held in the main part 1. The LCD display 2 is fitted on the main part 1 while the control device 3 is disposed in the main part 1.

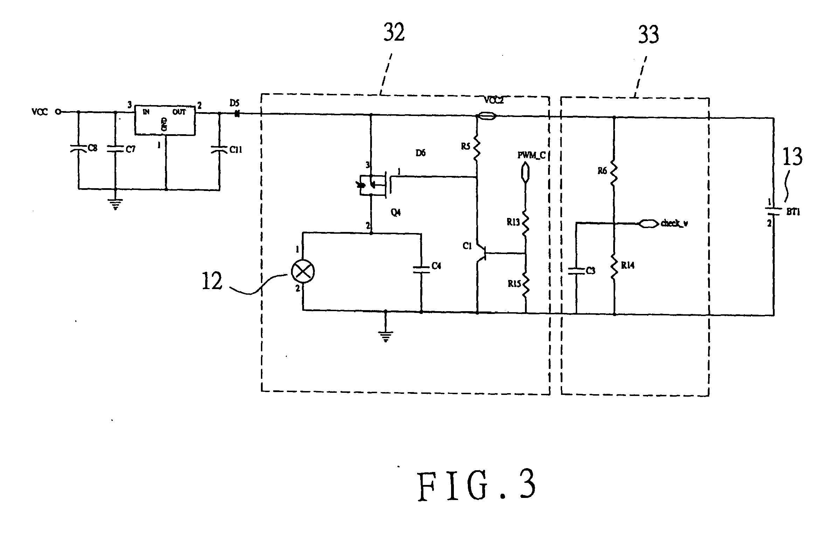

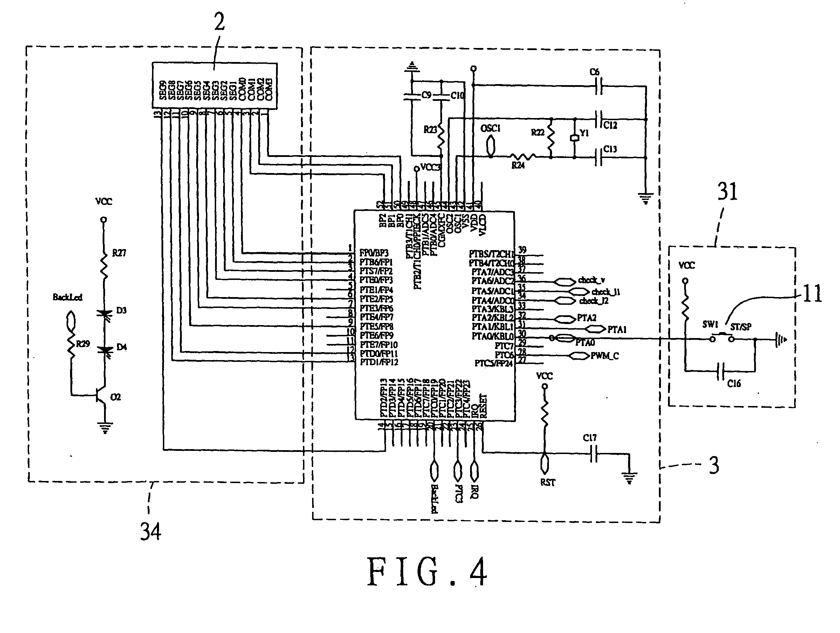

Referring to Figs. 1 to 4, the control device 3 includes a function switching unit 31, a light source controlling unit 32, an electricity content checking and measuring unit 33, and an LCD displaying unit 34. The function switching unit 31 is connected to the switch 11 fitted on the main part 1. The light source controlling unit 32 is connected to the light source 12 on the front end of the main part 1. The electricity content checking and measuring unit 33 is connected to the batteries 13 held in the main part 1. And, the LCD displaying unit 34 is connected to the LCD display 2.

Therefore, in use, the control device 3 will measure the amount of electricity left in the batteries 13 through the electricity content checking and measuring unit 33; in the measurement, the electricity amount checking and measuring unit 33 will acquire data on the electricity content of the batteries 13, which data will be first transformed into an analogue signal. Next, the analogue signal will be transformed into a digital signal by means of ADC (analogue-to-digital conversion) function of the control device 3, and a calculation will be carried out based on the digital signal with the result of the calculation, i.e. information on the electricity content of the batteries 13, being shown in the form of bars on the LCD display 2 through the LCD displaying unit 34. At the same time, the control device 3 will carry out calculation based on the electricity content of the batteries 13 so as to find out the length of time the batteries 13 will last, and the result of the calculation will also be shown on the LCD display 2 through the LCD displaying unit 34.

When the switch 11 is moved to a certain position, the function switching unit 31 of the control device 3 will detect change of the switch 11, and the control device 3 will send out a PWM (pulse-width modulation) pulse signal to the light source controlling unit 32 such that the light source controlling unit 32 makes the light source 12 shine in a certain manner according to a new position of the switch 11; the light source 12 can keep on shining or flash on and off repeatedly at various frequencies and with various brightnesses; in other words, the flashing frequency and brightness of the light source 12 can be changed with the help of the switch 11 and the control device 3. Furthermore, information about the way the light source 12 is producing light will also be shown on the LCD display 2 through the LCD displaying unit 34 at the same time. In addition, in emergency, the user is allowed to move the switch 11 such that the light source controlling unit 32 makes the light source 12 emit very bright light to serve as warning signals.

From the above description, it can be seen that the present invention is convenient to use, and has the following advantages: the flashlight of the present invention has the LCD display for showing information on the electricity content of the batteries as well as the length of time the batteries will last; with the help of both the switch and the control device, the flashlight can be switched so as to shine in either one of various ways, e.g. flashing on and off repeatedly at a certain frequency, and keeping on shining, and it can be switched so as to produce light of either one of various brightnesses; furthermore, the flashlight can be to switched so as to produce very bright light, which can serve as warning signals in emergency.

## Claims

1. Structure of a flashlight with LCD display, comprising
a main part,
a switch fitted on the main part,
a light source fitted to a front end of the main part,
a plurality of batteries held in the main part,
an LCD display fitted on the main part, and
a control device positioned in the main part, the control device including:
(a) an electricity content checking and measuring unit connected to the batteries for measuring amount of electricity left in the batteries; in measurement, the electricity content checking and measuring unit being going to acquire data on electricity content of the batteries, which data will be transformed into an analogue signal; the analogue signal being going to be transformed into a digital signal by means of ADC (analogue-to-digital conversion) function of the control device; and
(b) an LCD displaying unit connected to the LCD display; a calculation being going to be carried out based on said digital signal with result of said calculation being shown on the LCD display through the LCD displaying unit.

2. The flashlight structure as recited in claim 1, wherein the electricity content of the batteries is shown on the LCD display in a form of plural bars.

3. The flashlight structure as recited in claim 1, wherein the control device will carry out calculation based on the electricity content of the batteries so as to find out length of time the batteries will last; a result of said calculation being going to be shown on the LCD display.

4. The flashlight structure as recited in claim 1, wherein the control device further includes:
a function switching unit connected to the switch fitted on the main part, and
a light source controlling unit connected to the light source fitted on the front end of the main part; when the switch is displaced, the function switching unit will detect change of the switch, and the control device will send out a PWM (pulse-width modulation) pulse signal to the light source controlling unit such that the light source controlling unit makes the light source shine in a way according to position of the switch.

5. The flashlight structure as recited in claim 4, wherein brightness of the light source on the front end of the main part can be changed.

6. The flashlight structure as recited in claim 4, wherein the light source on the front end of the main part can flash on and off repeatedly, and flashing frequency of the light source can be changed.

7. The flashlight structure as recited in claim 4, wherein the light source on the front end of the main part can emit highly bright light.

8. The flashlight structure as recited in claim 4, wherein information about a way the light source is producing light will be shown on the LCD display through the LCD displaying unit at same time.
